# EUROPEAN PATENT APPLICATION

(11) **EP 1 521 306 A2**
(43) Date of publication of application: **06.04.2005**
(21) Application number: 04255999.7
(22) Date of filing: 29.09.2004
(51) Int. Cl.: H01L 29/737, H01L 29/732, H01L 21/331

(54) **Bipolar transistor and method of manufacturing the same**

(30) Priority: 30.09.2003 US 507374 P
(71) Applicant: Agere Systems, Inc., Allentown, PA 18109 (US)
(72) Inventor: Carroll Michael Scott, Orlando, FL 32837 (US); Kerr Daniel Charles, Orlando, FL 32836 (US); Chen alan Sangone, Windemere, FL 34786 (US); Russel William A., Orlando, FL 32819 (US); Jones Robert Francis, Clermont, FL 34711 (US)
(74) Representative: Williams, David John

(57) **Abstract**

A process for forming an emitter for a bipolar junction transistor and a bipolar junction transistor formed according to the process. In one embodiment, the bipolar junction transistor comprises in stacked relation a collector, an intrinsic base, an extrinsic base and an emitter. The emitter is formed by defining an opening in material layers forming the extrinsic base and selectively depositing silicon in the opening. The silicon is doped in situ or by an implant process. In another embodiment lacking an extrinsic base the opening is formed in dielectric material layers overlying the intrinsic base.

## Description

This invention claims the benefit of the provisional patent application filed on September 30, 2003, entitled Bipolar Transistor with Selectively Deposited Emitter and assigned application number 60/507,374.

### FIELD OF THE INVENTION

This invention relates generally to bipolar transistors, and more specifically to a process for forming an emitter region of a bipolar transistor and a transistor formed according to such a process.

### BACKGROUND OF THE INVENTION

A bipolar junction transistor (BJT) comprises three adjacent doped semiconductor regions or layers having an NPN or PNP doping configuration. A middle region forms a base and two end regions form an emitter and a collector. Typically, the emitter has a higher dopant concentration than the base and the collector, and the base has a higher dopant concentration than the collector. Generally, the BJT can be operated as an amplifier (for example, to amplify an input signal supplied between the base and the emitter, with the output signal appearing across the emitter/collector) or as a switch (for example, an input signal applied across the base/emitter switches the emitter/collector circuit to an opened or a closed (i.e., short-circuited) state.

There are several known semiconductor fabrication processes for forming the three doped layers of a bipolar transistor and several transistor architectures can be formed according to such processes. The simplest structure is a planar architecture with stacked NPN or PNP regions formed by successive dopant implantations into a substrate. Significant performance enhancements are achieved by forming the emitter from a single layer of polysilicon. For example, using a polysilicon emitter allows greater control over the emitter-base doping profile. A second significant enhancement can be achieved by using two layers of polysilicon, one for the emitter and the other for an extrinsic base region. This architecture reduces base resistance and collector-base capacitance, among other advantages.

With respect to the second mentioned process employing two polysilicon layers, (referred to as a double polysilicon layer process), disadvantageously deposition of an emitter polysilicon layer across the entire substrate necessitates the use of masking, patterning and etching steps to define the emitter. Further, additional material layers are required to form spacers between the extrinsic base polysilicon layer and the emitter polysilicon layer. The masking, patterning and etching of these material layers can be a complicated process that is prone to produce operational difficulties in the resulting devices.

Also, according to the double polysilicon layer processes, as the emitter polysilicon layer deposits in an emitter window, the polysilicon deposits on both the bottom surface and sidewalls of the window. The bottom window surface is formed by the base region, and thus the polysilicon deposited on the bottom surface forms a base/emitter junction. The polysilicon formed on the bottom window surface tends to be thinner than a fully deposited layer thickness due to a pinch-off condition caused as polysilicon is deposited on window sidewalls, interfering with polysilicon deposition on the window bottom surface. If the polysilicon material on the bottom window surface material is too thin, the bipolar junction transistor may not function properly. As emitter window width is reduced to achieve higher transistor operating speeds, the problem of emitter polysilicon window pinch-off is exacerbated.

Although the single polysilicon layer process (also referred to as an implanted base process) avoids certain of these disadvantages. The masking, patterning and etching steps required to form the base and the emitter can also involve complicated process steps that are prone to produce devices that do not function properly. The window pinch-off problem is also observed during deposition of the polysilicon layer in the emitter window.

### BRIEF SUMMARY OF THE INVENTION

An embodiment of the present invention comprises a process for forming an emitter of a bipolar junction transistor. The process comprises providing a substrate having a base therein, forming a material layer overlying the substrate, forming an opening in the material layer exposing the base and selectively depositing the emitter within the opening.

A structure according to the present invention comprises a substrate, a collector disposed in the substrate, an intrinsic base overlying the collector, an extrinsic base laterally adjacent the intrinsic base, a dielectric layer overlying the intrinsic base, wherein an opening is defined in the dielectric layer and an emitter in the opening, wherein the emitter is confined to the opening.

### BRIEF DESCRIPTION OF THE DRAWINGS

The foregoing and other features of the invention will be apparent from the following more particular description of the invention, as illustrated in the accompanying drawings, in which like reference characters refer to the same parts throughout the different figures. The drawings are not necessarily to scale, emphasis instead being placed upon illustrating the principles of the invention.

Figures 1-7 are cross-sectional illustrations of sequential processing steps for forming a bipolar junction transistor and metal-oxide semiconductor field effect transistors according to a first method of the present invention.

Figures 8-14 are cross-sectional illustrations of sequential processing steps for forming a bipolar junction transistor and metal-oxide semiconductor field effect transistors according to a second method of the prior art.

### DETAILED DESCRIPTION OF THE INVENTION

Before describing in detail the particular method and apparatus for forming a bipolar junction transistor on a semiconductor integrated circuit, it should be observed that the present invention resides primarily in a novel and non-obvious combination of elements and process steps. Accordingly, the inventive elements and steps have been represented by conventional elements and steps in the drawings, showing only those specific details that are pertinent to the present invention so as not to obscure the disclosure with details that will be readily apparent to those skilled in the art having the benefit of the description herein.

According to the teachings of the present invention, the emitter polysilicon for the BJT is deposited only where required during a selective deposition process. To achieve the selective deposition, the emitter silicon can be deposited in a conventional selective silicon deposition system using HCl (hydrochloric acid). In another embodiment, selective deposition can be achieved in a system that advantageously utilizes the time lag between the start of silicon growth on a clean silicon surface and the start of silicon growth on a silicon dioxide or a silicon nitride surface.

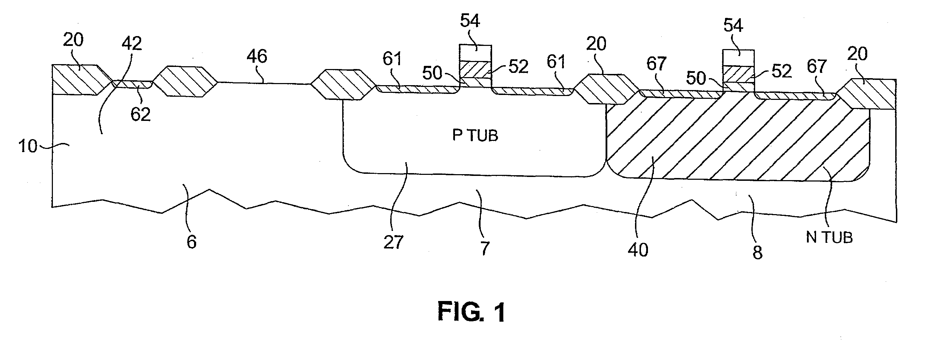

A process sequence for forming a selectively deposited emitter for a NPN bipolar junction transistor architecture, according to the teachings of the present invention, and further comprising an implanted base, is described below in conjunction with the Figures 1-10, which show cross-sectional views of the formed structures according to sequential processing steps. The illustrated prior art process is a BiCMOS process, wherein bipolar transistors and CMOS (complimentary metal oxide semiconductor field effect transistors) are formed on a substrate. According to the process steps, an NPN BJT is formed in a region 6, an NMOSFET is formed in a region 7 and a PMOSFET is formed in a region 8 of a substrate 10. See Figure 1.

To avoid performance degradation and electrical cross-talk between the devices, it is necessary to electrically isolate the BJTs and the CMOS devices. The illustrated exemplary process employs LOCOS (local oxidation of silicon) isolation. The LOCOS regions are formed by first oxidizing the p-type silicon substrate 10 (see Figure 1) to form a silicon dioxide layer, also referred to as a pad oxide layer. A silicon nitride layer (not shown) is deposited overlying the silicon dioxide layer. The silicon nitride layer and the silicon dioxide layer are etched according to an overlying patterned photoresist layer to form openings therein. The remaining regions form an oxidation mask for subsequent LOCOS oxidation, permitting oxidation of the substrate 10 only through openings in the silicon nitride and silicon dioxide layers. The LOCOS oxidation process forms isolation silicon dioxide regions 20 as illustrated in Figure 1.

After forming the isolation regions 20, the remaining regions of the silicon nitride and the silicon dioxide layers are chemically stripped and a sacrificial silicon dioxide layer is formed over the substrate 10 in regions between adjacent isolation regions 20.

It is known that in other embodiments, other isolation structures, such as shallow and deep trench isolation structures, can be used alone or in combination with other isolation structures.

Next, a photoresist layer is deposited, masked, patterned and developed to form a p-tub photoresist implant mask (not shown). A p-type dopant is implanted through the mask to form a p-tub 27 in the NMOS region 7 of the substrate 10. See Figure 1.

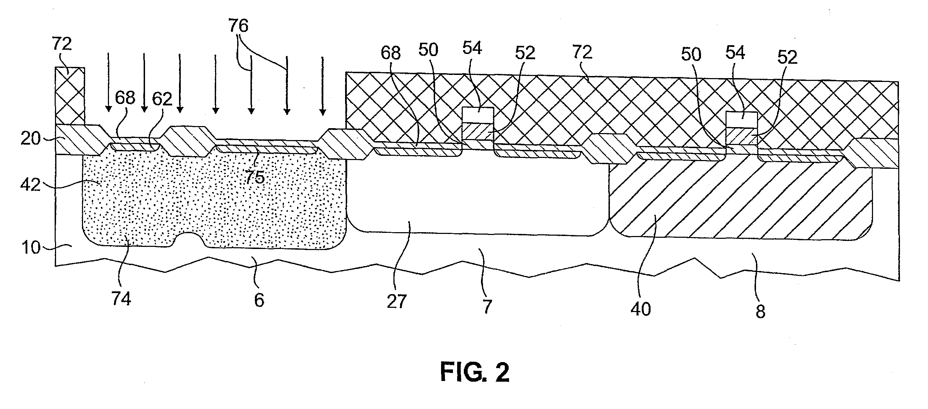

Next an n-tub photoresist implant mask is formed and n-type dopants implanted through the mask, forming an n-tub 40 in the PMOS region 8 and a collector region 42 for an NPN BJT device. The collector region 42 serves as a sinker region for connecting to a subsequently formed subcollector (as described below in conjunction with Figure 2).

To form a CMOS gate stack, a wet clean process removes the n-tub photoresist mask and the sacrificial silicon dioxide layer. A silicon dioxide layer, a polysilicon layer and a tungsten silicide layer are blanket deposited on an upper surface 46 of the substrate 10.

The polysilicon layer is doped through an implant mask, and the layers are patterned to form the gate stack layers. The resulting gate stack structure comprises gate oxide regions 50, polysilicon regions 52 and tungsten silicide regions 54 over each of the p-tub 27 (in the NMOS region 7) and the n-tub 40 (in the PMOS region 8).

Using an appropriately patterned implant mask, n-type lightly doped drain regions 61 (NLDD) are formed in the p-tub 27 and an n-type lightly doped collector contact region 62 is formed in the BJT region 6. Using an appropriately patterned implant mask, p-type lightly doped drain regions 67 (PLDD) are formed in the n-tub 40.

A TEOS (tetraethylorthosilicate) silicon dioxide layer 68 is formed overlying the substrate 10. See Figure 2. Using a subcollector mask 72, a subcollector 74 is implanted (as represented by n-type implant arrowheads 76) in the BJT region 6. After forming the subcollector 74, a p-type base 75 is formed over the subcollector 74 by implant counterdoping using a p-type dopant.

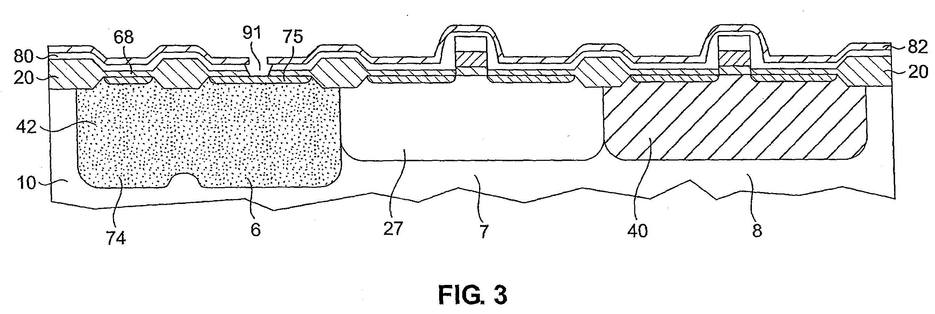

As shown in Figure 3, a spacer silicon dioxide layer 80 is deposited over the substrate 10. In one embodiment the layer 80 is formed by a TEOS process. In one embodiment, a relatively thin amorphous silicon layer 82 is deposited over the silicon dioxide layer 80 to serve as a mask for a subsequent wet etch step. Using a patterned photoresist layer (not shown), the amorphous silicon layer 82 and the underlying silicon dioxide layer 80 are anisotropically etched to form an emitter window 91. The etch process stops on the TEOS layer 68, which is removed from the emitter window 91, as shown, during a subsequent wet etch process.

According to the prior art, a polysilicon layer (not shown) is blanket deposited (including within the emitter window 91) for use in forming the BJT emitter. The polysilicon layer is implanted (or doped in-situ) with arsenic or another n-type dopant.

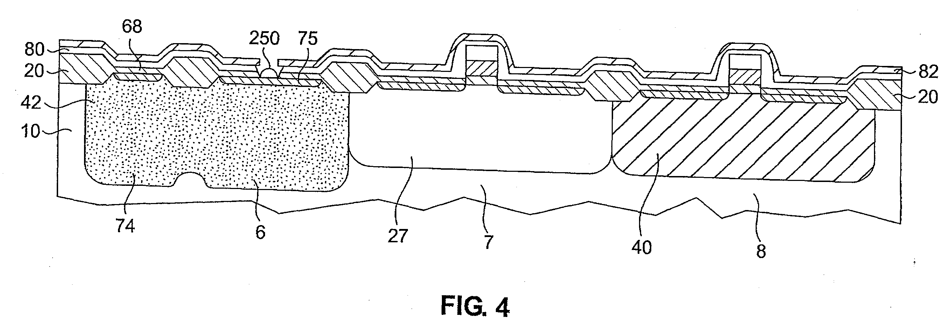

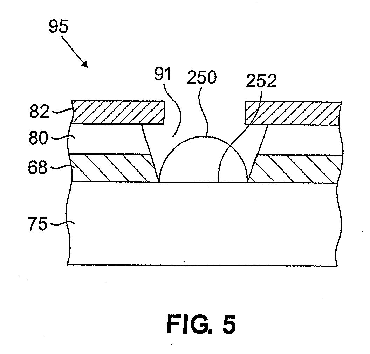

In lieu of depositing and patterning the polysilicon layer, according to the teachings of the present invention, a silicon emitter 250 (see Figure 4) is selectively deposited in the emitter window 91 on a surface 252 (silicon) of the base 75. See also the close-up view illustrated in Figure 5. By selective deposition is meant the deposition of silicon on bare silicon, but not on silicon dioxide or silicon nitride. The selective silicon deposition is performed in a hydrochloric acid (HCl) atmosphere (in one embodiment), permitting the deposition of silicon only in regions where bare silicon is exposed, such as the silicon surface 252 of the base 75. In effect, the silicon grows across the entire substrate 10, but the silicon etch rate on the dielectric surfaces is faster than the growth rate on those dielectric surfaces. Thus the silicon is selectively deposited only on the silicon surfaces.

The emitter formed according to the teachings of the present invention can be doped in-situ or implanted after deposition. To implant the dopants, in one embodiment a mask is formed to prevent dopant implants in regions of the substrate 10 other than the emitter 250. In another embodiment a mask may be unnecessary, depending on the thickness of the silicon dioxide layer 82 overlying the substrate 10, which may form a suitable mask for the implant step.

Advantageously, the deposition and patterning of the emitter 250 occur in the same process step. The prior art process steps associated with etching the blanket polysilicon layer are thus not required to form the emitter.

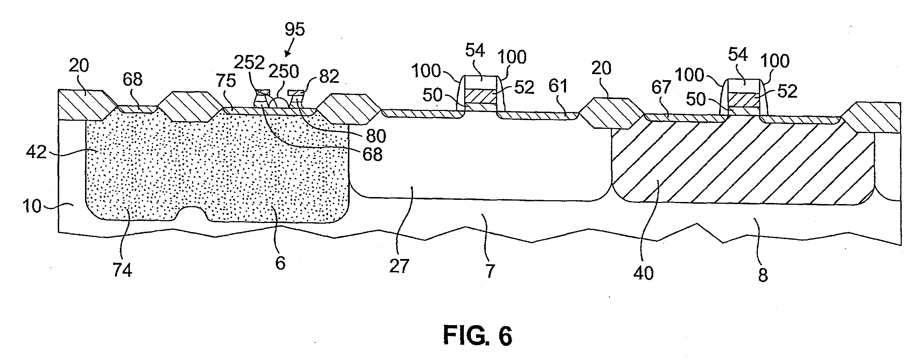

Gate stack spacers 100 for the PMOSFET and NMOSFET devices are formed by removing the layer 82, and anisotropically etching the silicon dioxide layer 80. During this etching process, the TEOS silicon dioxide layer 68 is also removed. See the resulting structure illustrated in Figure 6.

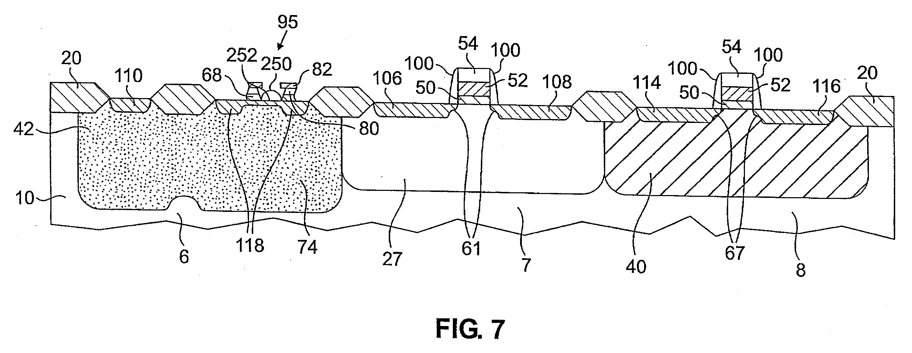

A photoresist layer is deposited and patterned to form an n+ source/drain mask for implanting a high dose (n+) of arsenic into the p-tub 27, forming a source 106 and a drain 108 for the NMOS region 6. See Figure 7. Arsenic is also implanted into the BJT collector region 42 through the same mask, forming an n+ ohmic collector contact region 110 with a relatively high doping level to minimize contact resistance with a subsequently-formed overlying collector contact.

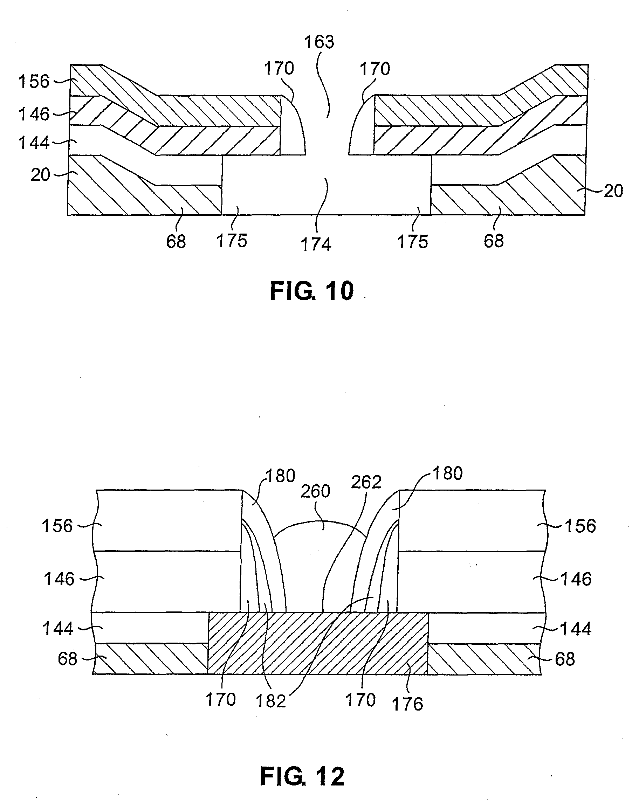

A high dose of a p-type dopant is implanted through a patterned mask into the n-tub 40 to form a source 114 and a drain 116 for the PMOS region 8. An extrinsic base region 118 of the NPN BJT 95 is also formed by the p-type dopant. Thus Figure 10 illustrates the final device appearance, prior to deposition of a dielectric layer overlying the substrate and additional dielectric layers disposed between metallization layers for interconnecting the doped regions formed in the substrate 10.

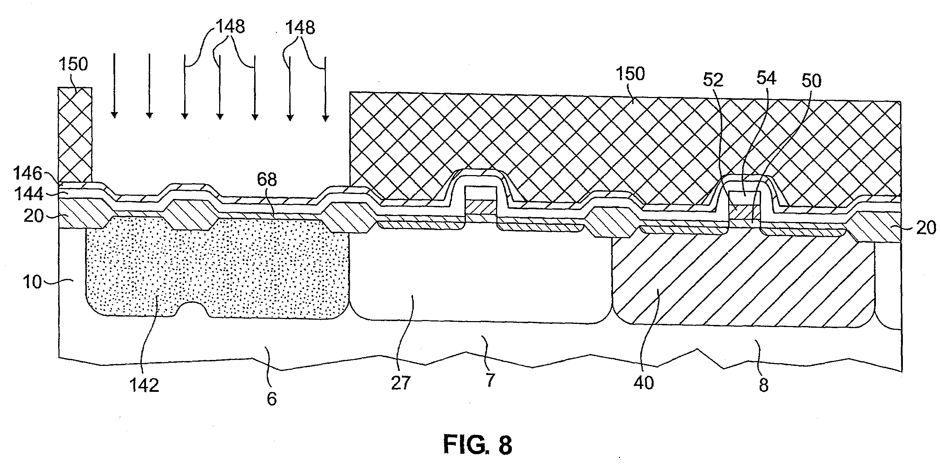

Application of the teachings of the present invention for forming a selectively deposited emitter to a process for forming an NPN BJT comprising a base region formed from a polysilicon layer is described below in Figures 8-14, which show cross-sectional views of the formed structures according to sequential processing steps. The illustrated process is a BiCMOS process, wherein bipolar transistors and CMOS (complimentary metal oxide semiconductor field effect transistors) are formed on a substrate. The teachings of the present invention can also be applied to formation of BJT's on a substrate without the formation of CMOS transistors on the same substrate.

Initial processing steps for the embodiment comprising a polysilicon base region are substantially identical to the processing steps set forth in Figure 1 above for the implanted base region. The additional steps of the polysilicon base process are illustrated beginning in Figure 8, which follows the process steps illustrated in Figure 1.

Figure 8 illustrates a subcollector 142 formed by n-type implant doping through a suitably patterned mask (not shown). A TEOS spacer oxide layer 144 and a polysilicon layer 146 are formed on the substrate 10. The polysilicon layer 146 is doped with a high-dose implant of boron (represented by implant arrowheads 148) through an implant mask 150. The boron implanted polysilicon layer 146 will form an extrinsic base region as described below.

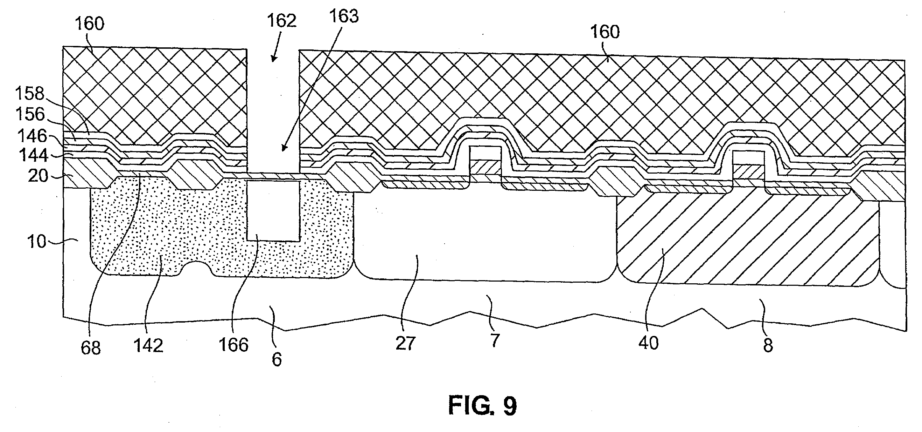

As illustrated in Figure 9, a silicon nitride layer 156 and a silicon dioxide layer 158 (in one embodiment formed according to a TEOS process) are deposited over the polysilicon layer 146. A photoresist layer 160 is deposited and patterned to form a window 162 therein. The silicon dioxide layer 158, the silicon nitride layer 156 and the polysilicon layer 146 are anisotropically etched through the window 162, stopping on the TEOS layer 144, to form an emitter window 163 in the substrate 10. In certain embodiments a collector region 166 is implanted through the window 162.

After the silicon dioxide layer 158 and the photoresist layer 160 are removed, a layer of silicon nitride is deposited and anisotropically etched to form sidewall spacers 170. See Figure 10. A wet etch process removes the silicon dioxide TEOS layers 68 and 144 from within the emitter window 163, forming a primary cavity 174 and cavities 175 laterally disposed relative to the primary cavity 174.

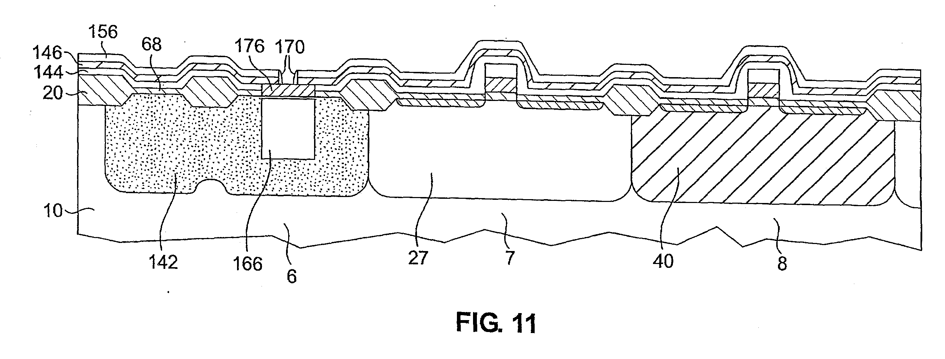

An intrinsic base and a cap region, both referred to by a reference character 176 (see Figure 11) are formed in the cavities 174 and 175 during a silicon-germanium epitaxial growth step.

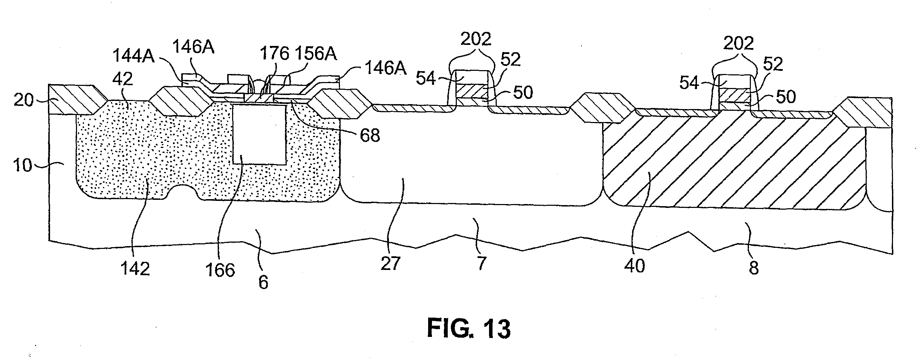

A silicon nitride spacer 180 and an underlying silicon dioxide (TEOS) spacer 182 are formed in the window 163 as illustrated in the close-up view of Figure 12. The spacers, which serve to increase the space between a later-formed n+ emitter and a p+ extrinsic base, are formed by depositing a TEOS silicon dioxide layer and a silicon nitride layer. The layers are anisotropically etched back to form the spacers 180 and 182, with the etch stopping on a region of the TEOS layer formed on an upper surface of the intrinsic base and cap region 176. In another embodiment the spacers 180 and 182 may not be required as the previously formed spacers 170 are sufficient. Following spacer formation, the remaining region of the TEOS silicon dioxide layer overlying the upper surface of the intrinsic base and cap region 173 is removed by a wet etch process.

As further illustrated in Figure 12, an emitter 260 is deposited selectively in a hydrochloric acid (HCl) atmosphere (in one embodiment) as described above, permitting the deposition of silicon only on a silicon surface 262 of the intrinsic base 176. The emitter can be doped in-situ or implanted after deposition. The implant step may be accomplished either masked or unmasked, depending on the thickness of the silicon nitride layer 156 overlying the base polysilicon layer 146. That is, if the silicon nitride layer 156 is sufficiently thick to block the implanted dopants in all regions except in the emitter 260, then a mask layer may not be necessary.

The BiCMOS process continues by using a patterned hard mask or photoresist mask to etch the polysilicon layer 146, forming extrinsic base regions 146A. At this point processing of the BJT is essentially complete. The BJT comprises (as shown in Figure 13) the intrinsic base 176, the extrinsic base regions 146A (formed from doped polysilicon), the selectively deposited emitter 260 and the collector regions 42, 142 and 66.

As further illustrated in Figure 13, a spacer etch step anisotropically etches the TEOS layer 144 and the silicon nitride layer 156 to form spacers 202 for the gate stack.

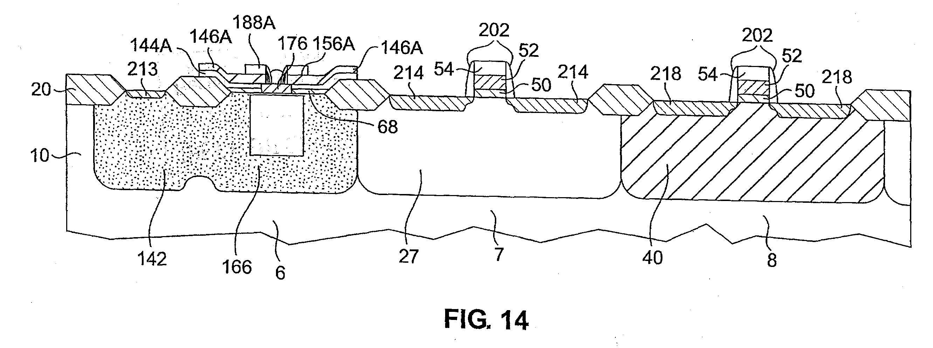

An n-type impurity is implanted through an appropriately patterned mask to form source/drain regions 214 and a collector contact 213. See Figure 14. A p-type impurity is implanted in the n-tub 40 to form source/drain regions 218.

Figure 14 illustrates a preferred final configuration of the various elements prior to deposition of the first dielectric layer and the first metallization interconnect layer. As is known in the art, windows are defined in the first dielectric layer and conductive plugs formed therein for establishing electrical contact with the various regions of the BJT and the two MOSFET's. Interconnect structures for connecting the regions are formed in the first metallization layer. Additional alternating dielectric layers and interconnect layers are formed over the first metallization layer to complete the interconnect system of the integrated circuit.

It has been observed that an emitter formed according to the teachings of the present invention (in either the implanted base or the polysilicon base embodiments) is formed of single-crystalline or polycrystalline material. The material crystalline structure is dependent on the growth conditions, growth surface cleaning techniques and other process parameters. Both the single-crystalline and the polycrystalline emitter embodiments are acceptable.

According to the present invention, since the emitter region deposits only upwardly from the base silicon, the width of the emitter window can be significantly reduced, compared to the prior art, without the resulting adverse window-narrowing effects encountered when the emitter is formed from a deposited polysilicon layer. Thus a BJT formed according to the present invention can provide a higher operating speed by using a narrower emitter window. Also, since the emitter polysilicon layer is absent, the overall height of the BJT structure is reduced as compared with a prior art BJT. The thick silicon nitride insulating layer 156, which is etched to form the silicon nitride region 156A (see Figure 13) between the extrinsic base region 146A and the emitter is not required for reducing the base/emitter capacitance. Also, the thickness of the lowest dielectric layer on which the conductive interconnects are formed is reduced.

By selectively depositing the emitter, this invention ameliorates the so-called "plug effect", where the arsenic n-type dopant concentration disadvantageously varies at the emitter-base interface due to thickness variations in the prior art emitter polysilicon layer across the emitter window 91. The profile of the selectively-deposited emitter (250 or 260), according to the teachings of the present invention does not cause the large thickness variations, thus avoiding the "plug effect."

Further, according to the prior art process, the emitter grows on the bottom and side surfaces of the opening, creating an emitter that may be thinner on the opening bottom surface than on the side surfaces. In certain situations, the material forming on the side surfaces can converge, "pinching off" the deposition process and creating a void between the pinched off region and the opening base. Such an improperly formed emitter can impair operation of the BJT due to the lack of sufficient emitter material in contact with the base region. This disadvantage is avoided according to the teachings of the present invention as the emitter fills the opening from the bottom during the selective deposition process.

An architecture and process have been described as useful for forming an emitter layer of a BJT in a semiconductor substrate. Specific applications and exemplary embodiments of the invention have been illustrated and discussed, which provide a basis for practicing the invention in a variety of ways and in a variety of circuit structures. Numerous variations are possible within the scope of the invention. Features and elements associated with one or more of the described embodiments are not to be construed as required elements for all embodiments. The invention is limited only by the claims that follow.

## Claims

1. A process for forming an emitter of a bipolar junction transistor, comprising:
providing a substrate having a base therein;
forming a material layer overlying the substrate;
forming an opening in the material layer exposing the base; and
selectively depositing the emitter within the opening.

2. The process of claim 1 wherein the emitter is doped in-situ or by implanting after the step of selectively depositing.

3. The process of claim 1 wherein the emitter comprises polycrystalline silicon deposited according to the selective deposition process.

4. The process of claim 1 wherein the emitter comprises single-crystalline silicon deposited according to the selective deposition process.

5. The process of claim 1 wherein the emitter deposits selectively from a bottom surface of the opening.

6. A process for forming a bipolar junction transistor, comprising:
providing a substrate;
forming a collector in the substrate;
forming an intrinsic base in the substrate and overlying the collector;
forming one or more material layers overlying the intrinsic base;
forming an opening in the one or more material layers, wherein the opening extends downwardly to the intrinsic base;
selectively depositing an emitter upwardly from the intrinsic base within the opening; and
forming an extrinsic base overlying at least a portion of the intrinsic base.

7. The process of claim 6 wherein the emitter is doped in-situ or by implanting after the step of selectively depositing.

8. The process of claim 6 wherein the emitter comprises polycrystalline silicon deposited according to the selective deposition process.

9. The process of claim 6 wherein the emitter comprises single-crystalline silicon deposited according to the selective deposition process.

10. The process of claim 6 wherein the emitter deposits selectively from a bottom surface of the opening.

11. A process for forming a bipolar junction transistor, comprising:
providing a substrate;
forming a collector in the substrate;
forming an intrinsic base overlying the collector;
forming material layers overlying the intrinsic base;
forming an opening in the material layers, wherein the opening comprises sidewalls and extends downwardly to the intrinsic base;
forming dielectric spacers along the sidewalls; and
selectively depositing an emitter upwardly from the intrinsic base within the opening.

12. The process of claim 11 wherein the emitter comprises polycrystalline silicon formed according to the selective deposition process.

13. The process of claim 11 wherein the emitter comprises single-crystalline silicon formed according to the selective deposition process.

14. The process of claim 11 further comprising a step of implanting dopants in the emitter.

15. The process of claim 11 further comprising doping the emitter in-situ.

16. The process of claim 11 wherein the step of forming dielectric spacers further comprises forming on the sidewalls a lateral stack of material layers comprising silicon dioxide and silicon nitride.

17. The process of claim 11 wherein the step of forming dielectric spacers further comprises forming silicon nitride spacers on the sidewalls.

18. The process of claim 11 wherein one of the material layers comprises a dielectric layer, wherein the step of forming an opening further comprises forming an opening in the dielectric layer, and wherein the opening comprises sidewalls and extends downwardly to the intrinsic base, wherein the process further comprises implanting dopants in the emitter through the opening, and wherein the implant dopants are prevented from reaching the substrate by the dielectric layer.

19. The process of claim 11 wherein the step of forming material layers further comprises forming a polysilicon material layer, etching and patterning the polysilicon material layer to form an extrinsic base.

20. The process of claim 11 wherein the emitter deposits selectively from a bottom surface of the opening.

21. A bipolar junction transistor comprising:
a substrate;
a collector disposed in the substrate;
an intrinsic base overlying the collector;
an extrinsic base in contact with the intrinsic base;
a dielectric layer overlying the intrinsic base and the extrinsic base, wherein an opening is defined in the dielectric layer; and
an emitter in the opening, wherein the emitter is confined to the opening.

22. The bipolar junction transistor of claim 21 wherein an upper surface of the emitter is within the opening.

23. The bipolar junction transistor of claim 21 wherein an upper surface of the emitter does not extend above sidewalls of the opening.

24. The bipolar junction transistor of claim 21 wherein the emitter presents a relatively flat upper surface.

25. The bipolar junction transistor of claim 21 wherein the opening is substantially devoid of voids.

26. The bipolar junction transistor of claim 21 wherein the emitter presents a substantially constant dopant concentration.

27. The bipolar junction transistor of claim 21 wherein a vertical line passing through the emitter does not pass through the extrinsic base.

28. A bipolar junction transistor comprising:
a semiconductor substrate;
a collector region formed in the substrate;
a base region formed in the substrate overlying the collector region;
a material layer overlying the substrate having a window formed therein;
an emitter region formed exclusively in the window.

29. The bipolar junction transistor of claim 28 wherein an upper surface of the emitter is within the opening.

30. The bipolar junction transistor of claim 28 wherein an upper surface of the emitter does not extend above sidewalls of the opening.

31. The bipolar junction transistor of claim 28 wherein the emitter presents a relatively flat upper surface.

32. The bipolar junction transistor of claim 28 wherein the opening is substantially devoid of voids.

33. The bipolar junction transistor of claim 28 wherein the emitter presents a substantially constant dopant concentration.
